# EUROPEAN PATENT APPLICATION

(11) **EP 3 863 088 A1**
(43) Date of publication of application: **11.08.2021**
(21) Application number: 19915572.2
(22) Date of filing: 06.12.2019
(51) Int. Cl.: H01M 4/36, H01M 4/38, H01M 4/587, H01M 4/62, C23C 16/24, C23C 16/32, C23C 16/44, H01M 10/052

(54) **ELECTRODE ACTIVE MATERIAL FOR SECONDARY BATTERY, ELECTRODE AND SECONDARY BATTERY WHICH COMPRISE SAME, AND METHOD FOR PREPARING ELECTRODE ACTIVE MATERIAL**

(71) Applicant: Livenergy Co., Ltd., Busan 48547 (KR)
(72) Inventor: JIN, Hong Soo, Busan 48091 (KR)
(74) Representative: RGTH
(86) International application number: PCT/KR2019/017162
(87) International publication number: WO 2021/112300

(57) **Abstract**

According to an embodiment of the present invention, an electrode active material for secondary battery is provided. The electrode active material according to an embodiment of the present invention may be formed using composite, which is a carbon-based material on which silicon layer is formed, as a unit powder. According to an embodiment of the present invention, the composite may comprise the silicon layer inside of the carbon-based material, and may be configured such that silicon is not exposed to an outer surface of the carbon-based material or locally exposed to only a portion of the outer surface of the carbon-based material. The silicon layer may be configured to include both silicon and carbon

## Description

### [Technical Field]

The present invention relates to an electrode active material for secondary battery, an electrode and a secondary battery including the same, and a manufacturing method for such an electrode active material, and more particularly, to an electrode active material for secondary battery, which is capable of providing a high capacity and high efficiency charge-discharge property by mixing silicon in carbon-based material, an electrode and a secondary battery including the same, and a manufacturing method for the electrode active material,.

### [Background Art]

In recent years, a lithium secondary battery has attracted attention as a power source for driving electronic devices. Such a lithium secondary battery has been extensively used in various fields from IT devices such as mobile phones to electric vehicles and energy storage devices.

The structure of the lithium secondary battery has been variously developed as application fields and demands of the lithium secondary battery have been increased. Various researches and developments have been actively conducted to improve capacity, lifespan, performance, safety, and the like of the battery.

As an example, although graphite-based material has been conventionally widely used as an electrode active material (negative electrode active material) of the lithium secondary battery, graphite has a capacity per unit mass of about 372 mAh/g, which causes a limit in increasing a capacity of the secondary battery. This makes difficult to sufficiently improve the performance of the secondary battery. In recent years, researches have been conducted to replace graphite-based material with another material that forms an electrochemical alloy with lithium, such as silicon (Si), tin (Sn), antimony (Sb), aluminum (Al) or the like.

However, such a material has a property that volumetric expansion/shrinkage occurs in the course of performing a charge-discharge operation to form an electrochemical alloy with lithium. Such a volume change due to the charge-discharge operation causes a volumetric expansion of the electrode, thereby degrading cycle characteristics of the secondary battery. As a result, the electrode active material manufactured using such a material has not yet been substantially commercialized.

For example, silicon is getting a lot of attention as an electrode active material for secondary battery, which can replace the graphite-based material. Silicon can absorb 4.4 lithium particles per one silicon to provide a high capacity. However, the volume of silicon is expanded by a factor of about 4 times in the course of absorbing the lithium particles (for reference, graphite which has been conventionally widely used as an electrode active material exhibits an expansion coefficient of about 1.2 times at the time of charge-discharge). As the charge-discharge of the secondary battery repeats, the expansion of the electrode may be increased and thus the cycle characteristic of the secondary battery may be degraded rapidly.

In order to solve this problem, a technique for forming an electrode active material by mixing silicon in carbon-based material such as graphite has recently been proposed. For example, Patent Documents 1 and 2 disclose techniques for forming a silicon layer on a carbon-based material such as graphite to improve the performance of the secondary battery.

Specifically, Patent Document 1 discloses a technique for forming a silicon coating layer on a surface of a carbon-based material such as graphite to ensure a high capacity compared to the conventional electrode active material formed of graphite, and reduce deterioration in cycle characteristic of the secondary battery due to expansion/shrinkage of silicon. However, the electrode active material disclosed in Patent Document 1 has a structure in which the silicon layer is provided on an outer surface of the carbon-based material. As a result, the external silicon layer may be significantly expanded and shrunk for the charge-discharge, and the electrode active material may be electrically short-circuited from the electrode or the surface of the electrode active material may be pulverized to accelerate the side reaction with the electrolyte. Such problems may cause deterioration in performance of the secondary battery.

On the other hand, Patent Document 2 discloses a technique for forming a silicon coating layer inside a carbon-based material such as graphite to improve performance of an electrode active material. Specifically, Patent Document 2 discloses a technique for forming the silicon coating layer in the cavities of the carbon-based material by spheroidizing the carbon-based material to form cavities therein and then depositing the silicon coating layer through a chemical vapor deposition (CVD). However, even in the case of the technique disclosed in Patent Document 2, the silicon coating layer is naturally deposited not only in the cavities formed inside the carbon-based material but also on an outer surface of the carbon-based material in the process of putting the carbon-based material having , which has cavities formed therein by the spheroidization, into a reaction chamber and supplying raw material gas into the reaction chamber to deposit the silicon coating layer. The silicon coating layer formed on the outer surface of the carbon-based material as described above is repeatedly expanded/shrunk in the course of the charge-discharge. This may be a cause of degrading the cycle characteristic of the secondary battery as the electrode active material disclosed in Patent Document 1.

Accordingly, in the field of secondary battery, there is still a need for an electrode active material and a manufacturing method thereof, which are capable of securing excellent cycle characteristics while improving the capacity of the battery.

### [Prior Art Documents]

Patent Document 1: Korean Patent No.10-1628873 (Registration Date: June 2, 2016)
Patent Document 2: Korean Patent No.10-1866004 (Registration Date: June 1, 2018)

### [Disclosure]

### [Technical Problem]

The present invention is directed to solve the aforementioned problems related to the conventional electrode active material for secondary battery, The present invention is to provide an electrode active material for secondary battery, which is capable of providing excellent cycle characteristics while improving the capacity of the secondary battery, an electrode and a secondary battery including the same, and a manufacturing method for the electrode active material.

### [Technical Solution]

Representative configurations of the present invention for achieving the abovementioned object are as follows.

According to an embodiment of the present invention, an electrode active material for secondary battery is provided. The electrode active material according to an embodiment of the present invention may be formed using composite, which is a carbon-based material on which silicon layer is formed, as a unit powder. According to an embodiment of the present invention, the composite may comprise the silicon layer inside of the carbon-based material, and may be configured such that silicon is not exposed to an outer surface of the carbon-based material or locally exposed to only a portion of the outer surface of the carbon-based material. The silicon layer may be configured to include both silicon and carbon.

According to an embodiment of the present invention, the composite may comprise the silicon layer only inside the carbon-based material, and may be configured such that silicon is not exposed to the outer surface of the carbon-based material.

According to an embodiment of the present invention, the silicon layer may be configured such that carbon is included in the silicon layer in a range of 17wt% to 27wt% with respect to a total weight of the silicon layer.

According to an embodiment of the present invention, silicon included in the silicon layer may have a particle diameter of 0.1 nm to 10 nm.

According to an embodiment of the present invention, silicon included in the silicon layer may have a particle diameter of 2 nm to 5 nm.

According to an embodiment of the present invention, the silicon layer may be formed such that SiC forms a base material and the silicon particles are distributed inside the SiC base material.

According to an embodiment of the present invention, silicon may be included in the composite in exceed of 10wt% with respect to a total weight of the composite.

According to an embodiment of the present invention, silicon may be included in the composite in exceed of 15wt% with respect to a total weight of the composite.

According to an embodiment of the present invention, the silicon layer may be deposited and formed on the carbon-based material by supplying both a first raw material gas containing silicon and a second raw material gas containing carbon .

According to an embodiment of the present invention, the first raw material gas containing silicon may include at least one gas selected from a group consisting of SiH₄, Si₂H₆, Si₃H₈, SiCl₄, SiHCl₃, Si₂Cl₆, SiH₂Cl₂, and SiH₃Cl, and the second raw material gas containing carbon may include at least one gas selected from a group consisting of C₂H₄, C₂H₂, and CH₄.

According to an embodiment of the present invention, a surface layer provided on an outer peripheral surface of the composite may be further provided.

According to an embodiment of the present invention, the surface layer may be formed of at least one carbon-based material selected from a group consisting of a coal tar pitch, a petroleum-based pitch, an epoxy resin, a phenolic resin, a polyvinyl alcohol, a polyvinyl chloride, an ethylene, an acetylene, and a methane.

According to an embodiment of the present invention, a negative electrode for secondary battery comprising the aforementioned electrode active material for secondary battery is provided.

According to an embodiment of the present invention, a secondary battery comprising a positive electrode, the aforementioned negative electrode, and an electrolyte provided between the positive electrode and the negative electrode.

According to an embodiment of the present invention, a method of manufacturing an electrode active material for secondary battery is provided. The method according to an embodiment of the present invention may comprise: base material preparation step of preparing carbon-based material used as a base material; silicon layer formation step of forming silicon layer on the carbon-based material; and spheroidization step of reassembling the carbon-based material on which the silicon layer is formed. In the silicon layer formation step, the silicon layer may be formed such that silicon and carbon are included in the silicon layer. The silicon layer may be configured to be located inside the carbon-based material through the spheroidization step, and may be configured such that silicon is not exposed to an outer surface of the carbon-based material or locally exposed to only a portion of the outer surface of the carbon-based material.

According to an embodiment of the present invention, in the silicon layer formation step, the silicon layer may be deposited and formed as a thin film layer on the carbon-based material through a chemical vapor deposition.

According to an embodiment of the present invention, in the silicon layer formation step, the silicon layer may be deposited and formed as a thin film layer on the carbon-based material by simultaneously supplying a first raw material containing silicon and a second raw material containing carbon.

According to an embodiment of the present invention, the first raw material gas containing silicon may include at least one gas selected from a group consisting of SiH₄, Si₂H₆, Si₃H₈, SiCl₄, SiHCl₃, Si₂Cl₆, SiH₂Cl₂, and SiH₃Cl, and the second raw material gas containing carbon may include at least one gas selected from a group consisting of C₂H₄, C₂H₂, and CH₄.

According to an embodiment of the present invention, in the silicon layer formation step, the silicon layer may be formed to include carbon in a range of 17wt% to 27wt% with respect to a total weight of the silicon layer.

According to an embodiment of the present invention, silicon included in the silicon layer may have a particle diameter of 0.1 nm to 10 nm.

According to an embodiment of the present invention, silicon included in the silicon layer may have the particle diameter of 2 nm to 5 nm.

According to an embodiment of the present invention, silicon may be included in the composite in exceed of 10wt% with respect to a total weight of the composite that forms the electrode active material.

According to an embodiment of the present invention, silicon may be included in the composite in exceed of 15wt% with respect to the total weight of the composite that forms the electrode active material.

According to an embodiment of the present invention, the spheroidization step may comprise: putting the carbon-based material on which the silicon layer is deposited into a spheroidization equipment, rotating the spheroidization equipment at a high speed to grind the carbon-based material on which the silicon layer is deposited, and reassembling fragments dropped by the grinding to spheroidize the carbon-based material on which the silicon layer is deposited; or edge-cutting the carbon-based material on which the silicon layer is deposited or applying a bending on the carbon-based material on which the silicon layer is deposited, and reassembling a structure by crumpling the carbon-based material on which the silicon layer is deposited to spheroidize the carbon-based material on which the silicon layer is deposited.

According to an embodiment of the present invention, a surface layer formation step of forming a surface layer on an outer peripheral surface of the carbon-based material on which the silicon layer is deposited may be further provided after the spheroidization step.

According to an embodiment of the present invention, a modification step of modifying a surface property of the carbon-based material used as a base material may be further provided between the base material preparation step and the silicon layer formation step.

In some embodiments, the electrode active material for secondary battery according to the present invention, the electrode (negative electrode) and the secondary battery including the same, and the method of manufacturing the electrode active material may further comprise other additional configurations without departing from the technical idea of the present invention.

### [Advantageous Effects]

The electrode active material according to an embodiment of the present invention is configured to be formed using the composite in which silicon is mixed in carbon-based material. Further, the electrode active material according to an embodiment of the present invention is configured such that silicon included in the composite is located inside the carbon-based material, and silicon is not exposed to an outer surface of the carbon-based material or is locally located only to a portion of the outer surface of the carbon-based material. Accordingly, the electrode active material according to an embodiment of the present invention can improve the capacity and performance of the secondary battery by silicon included in the electrode active material. Further, the electrode active material according to an embodiment of the present invention can reduce a problem in that the volume of the electrode is expanded due to expansion/shrinkage of the silicon particles, and significantly suppress a possibility that the electrode active material is electrically short-circuited from the electrode. Furthermore, the electrode active material according to an embodiment of the present invention can reduce a problem that a side reaction with electrolyte is accelerated due to silicon exposed to the outer surface, thereby providing a functional effect of greatly improving the performance and lifespan of the secondary battery.

Further, the electrode active material according to an embodiment of the present invention is configured such that both silicon and carbon are located in the carbon-based material used as a base material. Therefore, the volumetric expansion of the silicon particles can be alleviated inside the silicon layer which is formed together with carbon, which makes it is possible to further prevent the lifespan and performance of the secondary battery from being degraded due to the expansion/shrinkage of the silicon particles. Further, it is possible the electrode active material according to an embodiment of the present invention to reduce a particle diameter of silicon included in the silicon layer within a predetermined range by supplying both a first raw material gas containing silicon and a second raw material gas containing carbon to form the silicon layer including silicon and carbon. Thus, the electrode active material according to an embodiment of the present invention can prevent a problem of the volumetric expansion of silicon particles in a more effective manner.

### [Description of Drawings]

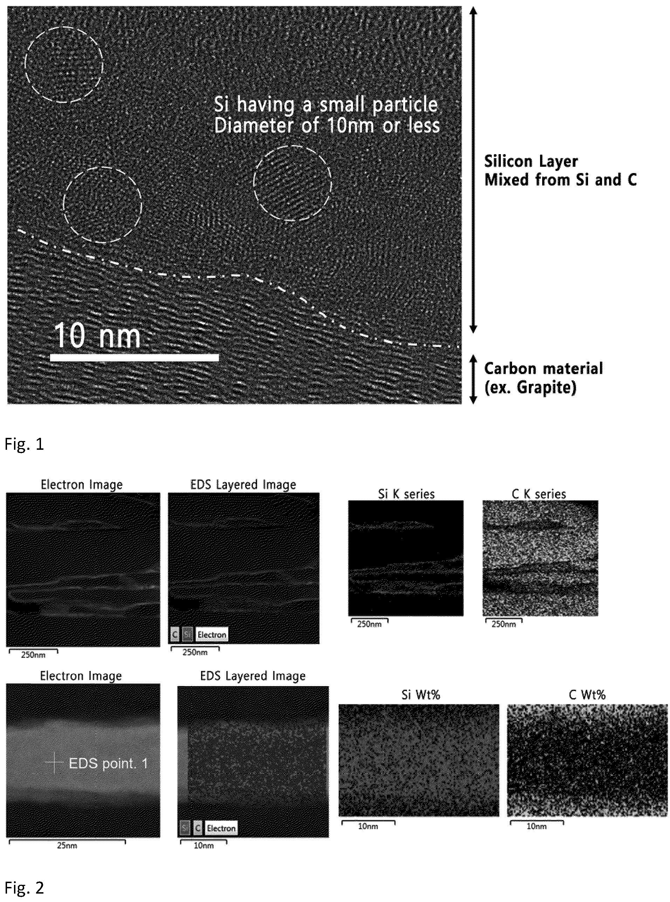

FIG. 1 shows an exemplary photograph of an electrode active material for secondary battery (a composite of carbon-based material and silicon) according to an embodiment of the present invention, which is observed with a transmission electron microscope (TEM).
FIG. 2 shows exemplary photographs of an electrode active material for secondary battery according to an embodiment of the present invention, which are observed with a scanning electron microscope (SEM) and an energy dispersive spectrometer (EDS).
FIG. 3 shows examples of performance of half-cells and a related composition obtained when an electrode active material for secondary battery according to an embodiment of the present invention is subjected to a heat treatment.
FIG. 4 shows examples of a change in performance of a battery depending on the content of carbon contained in a silicon layer.
FIG. 5 shows examples of the results of performance tests in a case in which the silicon layer is formed only inside the carbon-based material and a case in which the silicon layer is formed inside and outside the carbon-based material.
FIG. 6 shows examples of the thickness of electrolyte-decomposed byproducts formed on a surface of an electrode material and the degree of generation thereof, in the case in which the silicon layer is formed only inside the carbon-based material and the case in which the silicon layer is formed inside and outside the carbon-based material, which are observed with TEM.
FIG. 7 shows examples of a difference in electrode expansion generated by forming an electrode with a sample in which a silicon layer is formed only inside the carbon-based material and a sample in which a silicon layer is formed inside and outside the carbon-based material and then performing a charge-discharge operation 50 times with such electrodes, which are observed with SEM.
FIG. 8 shows changes in specific surface area characteristic of the carbon-based material (graphite) generated before and after a modification step.

### [Modes of the Invention]

Hereinafter, preferable embodiments of the present invention will be described in detail with reference to the appended drawings to such an extent that the present invention can be readily practiced by one of ordinary skill in the art.

Detailed descriptions of parts irrelevant to the present invention will be omitted for the purpose of more clearly describing the present invention. Throughout the specification, the same components will be described using like reference numerals. In addition, the shapes and sizes of the respective components shown in the drawings are arbitrarily shown for the sake of convenience in description, and thus the present invention is not necessarily limited to the illustrated shapes and sizes. That is, it should be understood that specific shapes, structures, and characteristics described in the specification may be modified in various embodiments without departing from the spirit and scope of the prevent invention, and positions or arrangements of individual components may be modified without departing from the spirit and scope of the prevent invention. Therefore, detailed descriptions to be described below should be construed as non-limitative senses, and the scope of the prevent invention should be understood to include appended claims and their equivalents.

### Electrode active material according to the present invention, and electrode and secondary battery including the same

According to an embodiment of the present invention, an electrode active material for secondary battery (negative electrode active material) in which silicon is mixed in carbon-based material may be provided.

As described above, graphite-based material that has been conventionally used as a negative electrode active material for lithium secondary battery has problems such as capacity limitation and a reduction in output characteristics at the time of high-speed charge. In the meantime, silicon material, which has attracted attention as a substitute for graphite, has low electrical conductivity and causes significant volumetric expansion at the time of charge-discharge. This may cause serious damage to the electrode active material and an electrode plate, and such a damage significantly deteriorates the cycle characteristic of the secondary battery. For that reason, there has been difficulties commercializing the electrode active material formed of silicon.

In contrast, the electrode active material according to an embodiment of the present invention is formed to have a structure in which silicon particles are mixed in carbon-based material, and thus the battery capacity can be significantly improved as compared with the conventional battery using graphite-based electrode active material. As will be described later, the silicon included in the electrode active material is configured such that the majority thereof is located inside the carbon-based material and a portion thereof is exposed locally to an outer surface of the carbon-based material (preferably, silicon is not exposed to the outer surface of the carbon-based material). This prevents a problem that silicon is exposed to electrolyte in the course of forming an electrode with the electrode active material through a rolling process and a side reaction occurs. Further, the silicon can be expanded and shrunk only inside the carbon-based material, which makes it is possible to suppress the lifespan shortening and performance degradation of the secondary battery due to the volumetric expansion of silicon.

Further, the electrode active material according to an embodiment of the present invention is configured to include both silicon and carbon in a silicon layer formed on the carbon-based material. Thus, silicon particles can be formed to be small in a predetermined range in the course of depositing the silicon layer including both silicon and carbon by a chemical vapor deposition or the like, which alleviates the problem of the volumetric expansion of silicon particles. Further, the volumetric expansion of silicon can be alleviated by carbon-containing substances (e.g., C, SiC, and the like) located around silicon particles, which makes it is possible to more effectively suppress the lifespan shortening and performance degradation of the secondary battery due to the volumetric expansion of silicon particles.

Specifically, the electrode active material according to an embodiment of the present invention may be formed of a composite in which silicon is mixed in carbon-based material using the carbon-based material as a base material. Such a composite may be a unit powder that forms an electrode active material for secondary battery. In some embodiments, the electrode active material may be configured by a large number of composites depending on a capacity of the secondary battery.

According to an embodiment of the present invention, the composite that forms the electrode active material may be configured such that silicon layer including silicon is formed on carbon-based material to form a composite electrode active material in which silicon is mixed in the carbon-based material (e.g., natural graphite, artificial graphite, hard carbon, or the like).

According to an embodiment of the present invention, the silicon layer may be deposited and formed on the carbon-based material by a method such as a chemical vapor deposition (CVD). The silicon layer may be formed only inside the carbon-based material, and may be formed so as not to be exposed to the outer surface of the carbon-based material (so as to be locally exposed only to a portion of the outer surface of the carbon-based material even if silicon is exposed).

As such, by forming the electrode active material using the composite as a unit powder such that silicon is not exposed to the outer surface of the electrode active material and exists only inside the electrode active material, it is possible to eliminate problems that the electrode plate is damaged by the expansion/shrinkage of silicon exposed to the outside and that the outwardly-exposed silicon is brought into contact with electrolyte to accelerate the side reaction. Thus, it is possible to significantly improve the performance and lifespan of the secondary battery.

According to an embodiment of the present invention, the silicon layer may be formed on the carbon-based material as a thin film by supplying a first raw material gas containing silicon and a second raw material gas containing carbon into a reaction chamber in which the carbon-based material serving as a base material is located.

For example, the silicon layer may be deposited by supplying both the first raw material gas containing silicon (e.g., raw material gas such as SiH₄, Si₂H₆, Si₃H₈, SiCl₄, SiHCl₃, Si₂Cl₆, SiH₂Cl₂, and SiH₃Cl, or the like) and the second raw material gas containing carbon (e.g., raw material gas such as C₂H₄, C₂H₂, and CH₄, or the like) into the reaction chamber heated at a temperature of 400°C to 700°C.

As described above, when the silicon layer is formed by supplying both the first raw material gas containing silicon and the second raw material gas containing carbon, silicon and carbon may coexist in the silicon layer. By carbon existing in the silicon layer, the volumetric expansion of silicon, which is generated at the time of charge-discharge, can be alleviated, which makes it is possible to suppress the lifespan shortening and performance degradation of the secondary battery due to the volumetric expansion of silicon.

In addition, as described above, when the silicon layer is deposited by supplying both the first raw material gas containing silicon and the second raw material gas containing carbon, the silicon particles contained in the silicon layer can be prevented from being agglomerated with each other and coarsened. Thus, the particle diameter of the silicon particles included in the silicon layer can be set to a small size of less than or equal to 10 nm (preferably, a small particle diameter of less than or equal to 5 nm). By forming the particle diameter of the silicon particles in a small size, it is possible to more effectively prevent damage of the electrode of the secondary battery and the lifespan shortening of the secondary battery due to the volumetric expansion of the silicon particles.

According to an embodiment of the present invention, the silicon particles included in the silicon layer may have a particle diameter of 1 nm to 10 nm, preferably a particle diameter of 2 nm to 5 nm. If silicon particles having a large particle diameter are included in the silicon layer, there is a concern that the stress of the silicon particles may be increased and the volumetric expansion of the silicon particles at the time of charge-discharge may be greatly increased, thereby resulting in the performance degradation and lifespan shortening of the secondary battery. Conversely, if silicon particles having an extremely small particle diameter are included in the silicon layer, a high level of resistance may be generated at the time of charge-discharge, thereby causing the performance degradation of the secondary battery. Accordingly, it is preferable that the silicon included in the silicon layer has a particle diameter falling within the aforementioned range.

According to an embodiment of the prevent invention, silicon and carbon included in the silicon layer may have the form of Si, C, or SiC. Preferably, most of silicon and carbon included in the silicon layer may have the form of Si and SiC, and a portion thereof may have the form of C. For example, according to an embodiment of the present invention, the silicon layer may be formed to have a structure in which SiC is used as a base material and Si particles are dispersedly positioned in the base material of SiC.

Typically, SiC does not contribute substantially for the capacity of the secondary battery. For this reason, from the viewpoint of the capacity of the secondary battery, it is preferable to make SiC as small as possible. However, in the case in which carbon existing in the silicon layer have the mixed form of C and SiC as a significant amount (e.g., a case in which SiC is not sufficiently generated because the silicon layer is deposited at a low temperature of 500°C or lower), a problem may occur in that different capacity characteristics exhibit each time when producing the aforementioned composite in which carbon-based material and silicon are mixed. Thus, in the electrode active material according to an embodiment of the present invention, it may be preferable that most of carbon existing in the silicon layer react with Si to form SiC.

According to an embodiment of the present invention, the silicon layer may be deposited at a relatively low temperature of 400°C to 700°C using the first raw material gas containing silicon and the second raw material gas containing carbon, and may be stabilized by performing a heat treatment at a high temperature of 700°C or higher (preferably, 900°C or higher).

According to an embodiment of the present invention, the content of carbon included in the silicon layer may be set to fall within a range of 17wt% to 27wt% with respect to the total weight of the silicon layer (herein, the content of carbon included in the silicon layer means the sum of the contents of all carbon, such as C, SiC and the like, included in the silicon layer, unless otherwise stated). If the content of carbon included in the silicon layer is less than 17wt%, a low capacity retention ratio of less than 90% may be provided. If the content of carbon exceeds 27wt%, there is a risk that a discharged capacity and an initial coulombic efficiency may be very rapidly decreased.

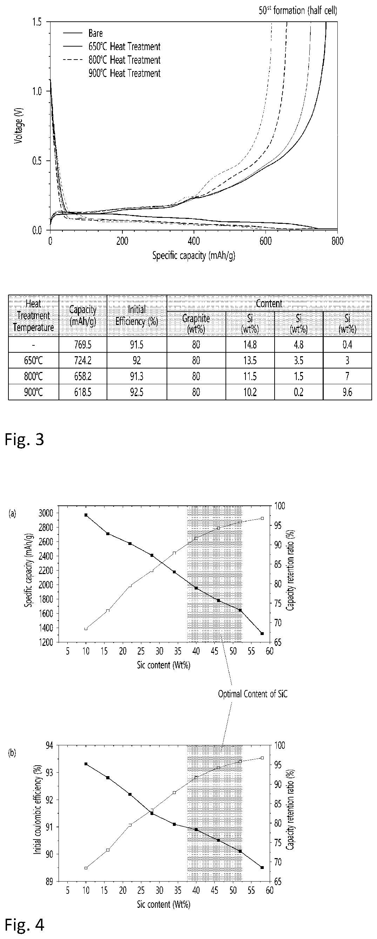

For example, in FIG. 4, there are shown examples of test data such as the discharged capacity, the capacity retention ratio, the initial coulombic efficiency, and the like depending on the content of carbon included in the silicon layer in the electrode active material according to an embodiment of the present invention.

Specifically, referring to FIG. 4, there are shown test data obtained by depositing a thin film layer of silicon on the carbon-based material using the first raw material gas containing silicon and the second raw material gas containing carbon, performing a heat treatment at a high temperature of 900°C or higher to form a silicon layer composed of Si and SiC, and then testing the discharged capacity, the capacity retention ratio, the initial coulombic efficiency and the like in terms of the content of SiC.

Referring to the test results shown in FIG. 4, it can be seen that when SiC is included in the silicon layer at a level of less than 34wt% with respect to the total weight of the silicon layer (that is, when C is included in the silicon layer at a level of less than 17wt% with respect to the total weight of the silicon layer), the capacity retention ratio has a low value of less than 90% as shown in FIGS. 4(a) and 4(b). In addition, it can be seen that when SiC is included in the silicon layer at a level of more than 54wt% with respect to the total weight of the silicon layer (that is, when C is included in the silicon layer in excess of 27wt% with respect to the total weight of the silicon layer), the discharged capacity is sharply decreased as illustrated in FIG. 4(a), or the initial coulombic efficiency is significantly lowered as illustrated in FIG. 4(b). Thus, the content of carbon included in the silicon layer may preferably be set to fall within the range of 17wt% to 27wt% with respect to the total weight of the silicon layer, as described above.

According to an embodiment of the present invention, silicon included in the composite that constitutes the electrode active material may be configured in exceed of 10wt%, preferably in exceed of 15wt% with respect to the total weight of the composite.

Silicon can provide a capacity larger than that of graphite. Accordingly, the capacity of the secondary battery can be further increased as a large amount of silicon is included in the electrode active material. However, silicon included in the electrode active material may significantly degrade the cycle characteristics of the secondary battery due to the volumetric expansion generated at the time of charge-discharge. Thus, there is a limit in increasing the amount of silicon to be added to the electrode active material.

For example, a conventionally-known silicon-graphite composite electrode active material is configured such that a small amount of silicon was included in the electrode active material to address the problem of degradation in cycle characteristic of the secondary battery due to the expansion/shrinkage of silicon.

However, the electrode active material according to an embodiment of the present invention is configured such that most of silicon is located inside the carbon-based material and is not exposed outward of the carbon-based material. Thus, even if silicon of more than 10wt% (more preferably, more than 15wt%) is included in the electrode active material, surface cracking due to the expansion/shrinkage of silicon can be suppressed. Therefore, a relatively large amount of silicon can be mixed in the carbon-based material such as graphite to form a composite, so that the capacity of the secondary battery can be further improved.

According to an embodiment of the present invention, a surface layer may be further provided on an outer peripheral surface of the composite composed of carbon-based material and silicon. The surface layer formed on the outer peripheral surface of the composite provides an electron transfer path to improve electrical conductivity and suppresses a volume change of silicon at the time of charge-discharge, thereby improving the stability of the electrode plate.

According to an embodiment of the present invention, the surface layer formed on the outer peripheral surface of the composite may be formed of another carbon material (e.g., at least one carbon material selected from a group consisting of coal tar pitch, petroleum-based pitch, epoxy resin, phenolic resin, polyvinyl alcohol, polyvinyl chloride, ethylene, acetylene, and methane), which is different from the carbon-based material (base material) constituting the composite.

However, the surface layer is not necessarily essential. The electrode active material may be formed without the surface layer. Alternatively, an additional coating layer (conductive coating layer or the like) may be formed in addition to the aforementioned surface layer made of carbon material.

Further, according to an embodiment of the present invention, an electrode (negative electrode) and a secondary battery including the aforementioned electrode active material may be provided.

Specifically, the electrode and the secondary battery according to an embodiment of the present invention may include the aforementioned electrode active material formed of the composite of carbon-based material and silicon. As described above, the composite of carbon-based material and silicon, which constitutes the electrode active material, may be formed to have a structure in which silicon is mixed in the carbon-based material and silicon is located together with the carbon.

With such a configuration, a silicon-graphite composite can be formed to have a structure in which silicon is mixed in the carbon-based material at the inside of the carbon-based material. Thus, it is possible to achieve an increase in capacity of the battery with silicon particles, and to effectively suppress the performance degradation and lifespan shortening of the secondary battery due to the volumetric expansion of silicon particles and the contact of silicon particles with the electrolyte. The volumetric expansion of silicon is alleviated by carbon located around the silicon, thus further addressing the problem of degrading the performance of the secondary battery, which is caused by the volumetric expansion of silicon.

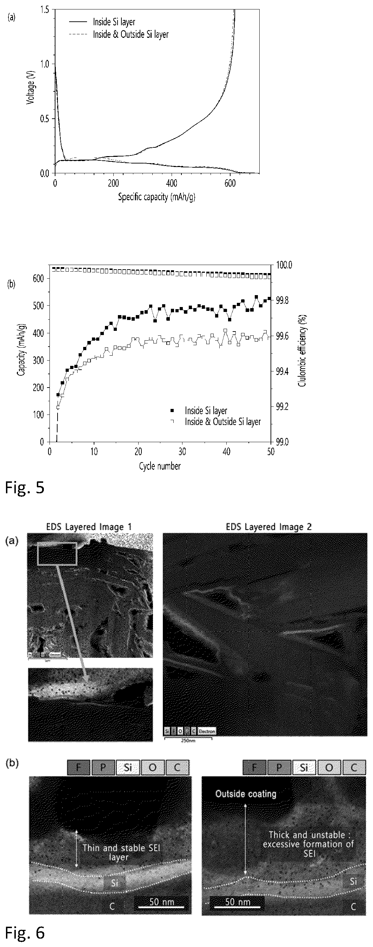

For example, FIGS. 5 to 7 show examples of performance comparison results in a case in which silicon layer is formed only inside carbon-based material (e.g., graphite) and a case in which silicon layer is formed both inside and outside carbon-based material (e.g., graphite).

Specifically, as shown in FIG. 5, it can be confirmed that, in the case in which the silicon layer is formed only inside the carbon-based material as the electrode active material according to an embodiment of the present invention, when the electrode active material is formed so as to have the same battery capacity, a relatively high coulombic efficiency exhibits as shown in FIG. 5(b) as compared to the case in which the silicon layer is formed inside and outside the carbon-based material. [For example, in the case in which the silicon layer is positioned only inside the carbon-based material, the coulombic efficiency of 99.8% exhibits after the charge-discharge is performed 50 times]

Further, it can be confirmed that, in the case in which the silicon layer is formed to be located only inside the carbon-based material as the electrode active material according to an embodiment of the present invention, side-reaction byproducts generated by reaction with the electrolyte is formed at a relatively small amount as shown in FIG. 6, as compared with the case in which the silicon layer is formed inside and outside the carbon-based material. [It can be confirmed that, in a sample in which the silicon layer is formed inside and outside the carbon-based material as shown in FIG. 6(b), a side-reaction byproduct layer (a layer including impurities such as F, P, and the like) is formed thicker than a sample in which the silicon layer is formed only inside the carbon-based material as shown in FIG. 6(a)].

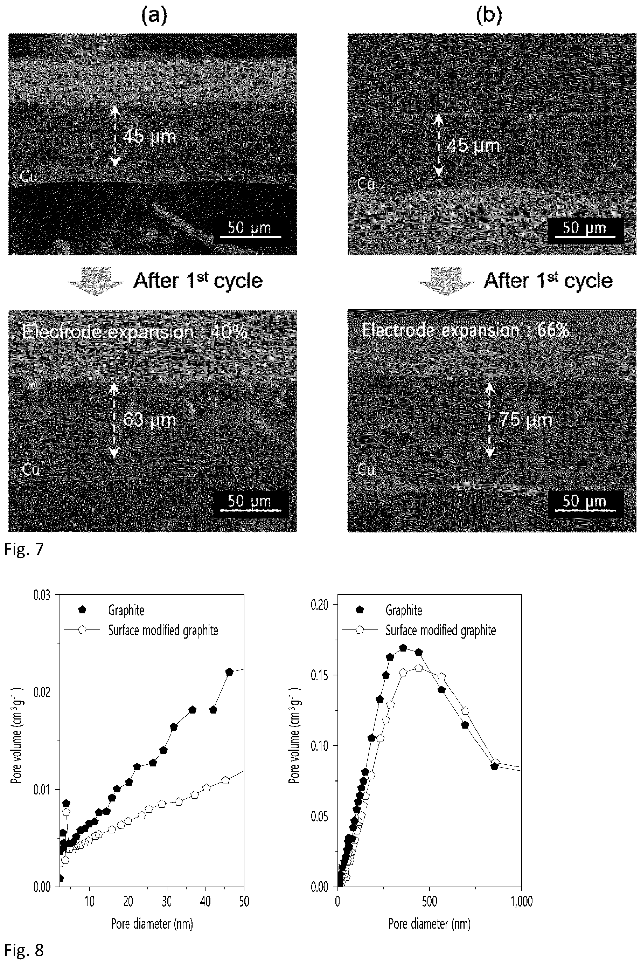

Furthermore, it can be confirmed that, in the case in which the silicon layer is formed to be located only inside the carbon-based material as the electrode active material according to an embodiment of the present invention, when the electrode is formed and the charge-discharge is performed 50 times, expansion of the electrode is generated at a relatively small level, as compared with the case in which the silicon layer is formed inside and outside the carbon-based material as shown in FIG. 7. [In the case in which the silicon layer is formed inside the carbon-based material as shown in FIG. 7(a), an electrode expansion coefficient of 40% exhibits when the charge-discharge is performed 50 times, whereas in the case in which the silicon layer is formed both inside and outside the carbon-based material as shown in FIG. 7(b), the electrode expansion coefficient of 66% exhibits when the charge-discharge is performed 50 times]

On the other hand, the electrode active material according to an embodiment of the present invention may be used for itself to form an electrode of the secondary battery. Further, the electrode active material according to an embodiment of the present invention may be mixed with the conventional electrode active material (e.g., an electrode active material formed of graphite-based material) to form an electrode active material for secondary battery.

As described above, the electrode active material according to an embodiment of the present invention can stably control the problem such as the electrode damage caused by the volumetric expansion of silicon. Thus, a relatively large amount of silicon can be included in the electrode active material as compared with the conventional electrode active material, which makes it is possible to sufficiently improve the battery capacity. Accordingly, although the electrode active material according to an embodiment of the present invention may be used in combination with the conventional electrode active material, it is possible to provide a capacity improvement effect sufficient than that in the conventional electrode active material. Furthermore, by using the electrode active material according to this embodiment in combination with the conventional electrode active material such as an electrode active material formed of graphite-based material, it is possible to more effectively control the problem of the volumetric expansion of silicon.

### Method of manufacturing electrode active material according to the present invention

According to an embodiment of the present invention, a method of manufacturing an electrode active material in which silicon is mixed in carbon-based material (specifically, a composite composed of carbon-based material and silicon) may be provided.

According to an embodiment of the present invention, the method of manufacturing an electrode active material (the composite of carbon-based material and silicon, which constitutes the electrode active material) may comprise: a base material preparation step of preparing a carbon-based material (such as a plate-like graphite); a silicon layer formation step of forming a silicon layer on the prepared carbon-based material; and a spheroidization step of mechanically grinding or crushing the carbon-based material on which the silicon layer is formed, edge-cutting the carbon-based material on which the silicon layer is formed, or applying bending to the carbon-based material on which the silicon layer is formed, for reassembling the carbon-based material on which the silicon layer is formed.

The base material preparation step is a step of preparing a carbon-based material that acts as a base material of the electrode active material according to an embodiment of the present invention. Example of the base material may include a natural graphite, an artificial graphite, a hard carbon, and the like. The base material may be formed a material having a particle size of 2 µm to 20 µm.

The silicon layer formation step is a step of forming the silicon layer on the carbon-based material that acts as a base material for high capacity of the electrode active material. The silicon layer may be formed as a thin film layer on a surface of the carbon-based material by a chemical vapor deposition or the like.

Specifically, the silicon layer may be formed by supplying a first raw material gas containing silicon and a second raw material gas containing carbon into a reaction chamber which has been heated to a temperature of 400°C to 700°C, and depositing the silicon layer on the surface of the carbon-based material which serves as a base material. The silicon layer formation step may be performed by supplying both the first raw material gas containing silicon, such as SiH₄, Si₂H₆, Si₃H₈, SiCl₄, SiHCl₃, Si₂Cl₆, SiH₂Cl₂, and SiH₃Cl, or the like, and the second raw material gas containing carbon, such as C₂H₄, C₂H₂, and CH₄, or the like, to the reaction chamber which has been heated to a temperature of 400°C to 700°C, and depositing the silicon layer as a thin film layer on the surface of the carbon-based material.

With this method, by supplying both the first raw material gas containing silicon and the second raw material gas containing carbon and performing the deposition of the silicon layer on the surface of the carbon-based material, both silicon and carbon can be included in the silicon layer. This makes it is possible to prevent silicon particles from being coarsely agglomerated inside the silicon layer. Thus, the silicon particles can be formed to have a small particle diameter.

According to an embodiment of the present invention, silicon included in the composite that constitutes the electrode active material may be formed in exceed of 10wt%, more preferably in exceed of 15wt% with respect to the total weight of the composite. The silicon layer including silicon may be formed as a thin film layer having a thickness in the range of 20 nm to 500 nm. Further, the silicon layer may be configured to include carbon in the range of 17wt% to 2wt7% with respect to the total weight of the silicon layer.

The spheroidization step performs a function of spheroidizing the carbon-based material on which the silicon layer is formed to reassemble a structure of the composite. This spheroidization step enables the silicon layer deposited on the surface of the carbon-based material to be moved and arranged into the carbon-based material, thus reassembling the structure of the composite.

For example, the spheroidization step may be performed by positioning the carbon-based material on which the silicon layer is deposited into a machine equipment provided with a rotational rotor and a blade, rotating the machine equipment at a high speed to grind the carbon-based material on which the silicon layer is deposited, and reassembling fragments dropped by the grinding to spheroidize the carbon-based material. Alternatively, the spheroidization step may be performed by crushing and pressing the carbon-based material on which the silicon layer is deposited to reassemble the carbon-based material. Alternatively, the spheroidization step may include edge-cutting the carbon-based material on which the silicon layer is deposited or applying a bending on the carbon-based material on which the silicon layer is deposited to be crumpled, for reassembling the structure of the carbon-based material.

According to an embodiment of the present invention, in order to prevent the carbon-based material or silicon from being oxidized due to strong frictional heat generated when reassembling the carbon-based material on which the silicon layer is deposited, the spheroidization step may be performed in a state in which an internal atmosphere is replaced with an inert gas such as N₂, Ar, or the like. Further, in order to improve a bonding force between the carbon-based material and the silicon layer, the spheroidization step may be performed in a state in which coal tar pitch, petroleum-based pitch, epoxy resin, phenolic resin, polyvinyl alcohol, polyvinyl chloride or the like is added as a binder.

In the meantime, according to an embodiment of the present invention, a modification step of modifying a surface property of the carbon-based material may be further provided after preparing the carbon-based material acting as a base material and before forming the silicon layer on the carbon-based material. The modification step is a step of filling fine pores existing in the carbon-based material used as a base material to prevent silicon from entering the fine pores. The fine pores may make it hard to secure a space to which silicon expand. By performing the modification step, the fine pores having a diameter of 50 nm or less and formed in the carbon-based material as a base material are filled with other amorphous or crystalline carbon material so that the specific surface area of the carbon-based material used as a base material can be reduced (in the modification step, the fine pores formed in the carbon-based material as a base material are filled with other amorphous or crystalline carbon so that the specific surface area can be reduced from a range of 2 to 10 m²/g to a range of 1 to 5 m²/g, as shown in FIG. 8). As a result, the silicon layer can be deposited only on large cavities existing in the carbon-based material used as a base material and the outer surface of the carbon-based material. The silicon layer formed in the fine pores is not provided with a sufficient space necessary for the expansion of silicon and thus may cause cracks in the carbon-based material such as graphite used as a base material. In contrast, when the modification step is performed, it is possible to prevent the silicon layer from being formed in the fine pores, thus further suppressing the electrode active material and the electrode using the same from being damaged.

According to an embodiment of the present invention, the modification step may comprise coating precursor such as petroleum-based pitch, coal-based pitch, resin, asphalt, methane, ethylene, acetylene or the like on a surface of the carbon-based material used as a base material. For example, the precursor such as petroleum-based pitch, coal-based pitch, resin, asphalt, or the like may be coated on the carbon-based material (base material) using a rotation furnace, an atmosphere furnace or the like. The modification step may be performed in a state of holding the carbon-based material for two or more hours in an inert gas atmosphere, such as N₂, Ar, or the like, at a temperature ranging from 600°C to 1,000°C. In the meantime, the precursor such as methane, ethylene, acetylene, or the like may be coated on the carbon-based material used as a base material with a vapor deposition apparatus, a rotary furnace or the like. For example, the precursor may be coated on the surface of the carbon-based material by flowing the precursor with respect to the carbon-based material at a flow rate of 3L to 8L per minute and at a temperature ranging from 800°C to 1,000°C.

The electrode active material according to an embodiment of the present invention, which is manufactured in the above method, is formed in a state that silicon is stably positioned inside the carbon-based material such as graphite. This makes it is possible to reduce the risk of causing a side-reaction due to the contact of silicon with electrolyte, and further achieve the performance improvement and prolonged lifespan of the electrode and the secondary battery.

According to an embodiment of the present invention, after the reassembling step, a heat treatment process may be performed to integrate a composite of the reassembled carbon-based material and silicon into a single structure, and to further enhance the structural stability of the silicon layer including silicon and carbon.

As described above, when the silicon layer is deposited on the surface of the carbon-based material at the temperature ranging from 400°C to 700°C in the silicon layer formation step, the deposition is performed in a state in which the first raw material gas containing silicon is smoothly decomposed and deposited, but the second raw material gas containing carbon is not sufficiently decomposed and a small amount of the second raw material is decomposed and deposited. In this case, a small amount of carbon reacts with silicon, whereby forming a SiC compound.

When the inventor of the present invention manufactured and tested samples of forming the silicon layer in such a manner, it was found that there is a concern that non-uniform capacity is formed every manufacturing process and, consequently, the above manner is hard to be applied to a mass-production process for commercialization.

On the other hand, when an additional heat treatment is performed at a temperature in the range of 700°C or higher (preferably, 900°C or higher) after the formation of the silicon layer, the silicon layer may be stabilized and the electrode active materials having uniform performance may be manufactured.

For example, referring to FIG. 3, there are shown test results obtained by supplying both the first raw material gas containing silicon and the second raw material gas containing carbon in a temperature environment of 550°C to form the silicon layer, and subsequently, performing the additional heat treatment at each temperature of 650°C, 800°C, and 900°C, and analyzing capacity, composition, and the like of the electrode active material.

As shown in FIG. 3, when the heat treatment is performed at a high temperature after the silicon layer is formed, silicon and carbon included in the silicon layer react with each other to form SiC. At this time, SiC does not contribute to the capacity of the secondary battery. Thus, as described above, the generation of SiC reduces the performance of the secondary battery. For example, as shown in FIG. 5, when the heat treatment is performed at a higher temperature after the silicon layer is formed, a relatively large amount of carbon reacts with silicon to form SiC. As a result, an amount of silicon is decreased and an amount of SiC is increased, so that the capacity of the secondary battery is gradually decreased.

Meanwhile, when the heat treatment is performed under a high-temperature environment after the formation of the silicon layer, the silicon layer can be stabilized and the electrode active material providing the same performance can be produced even when the electrode active material is repeatedly produced. Therefore, in order to commercially utilize the electrode active material according to an embodiment of the present invention, even if the initial battery capacity is slightly decreased, it is preferable to perform the heat treatment, at a high temperature of 700°C or higher (more preferably, 900°C or higher) on the silicon layer including silicon and carbon, which was formed at a temperature environment of 400°C to 700°C, so as to stabilize the silicon layer.

Further, according to an embodiment of the present invention, a surface layer formation step may be further provided to form a surface layer on an outer peripheral surface of the composite composed of carbon-based material and silicon, which is formed through the aforementioned steps. This surface layer may have a function of improving the electrical conductivity and improving the performance and lifespan of the electrode active material according to an embodiment of the present invention, the electrode and the secondary battery having the same.

According to an embodiment of the present invention, in the surface layer formation step, the surface layer may be formed using carbon material (e.g., other carbon-based material different from the carbon-based material used as a base material of the composite; coal tar pitch, petroleum-based pitch, epoxy resin, phenolic resin, polyvinyl alcohol, polyvinyl chloride, ethylene, acetylene, methane or the like) on the surface of the aforementioned composite in which carbon-based material and silicon are mixed. However, the surface layer is not necessarily essential. The electrode active material may be formed without the surface layer. In some embodiments, an additional coating layer (a conductive coating layer or the like) may be formed in addition to the surface layer of the aforementioned carbon material.

### Specific embodiments of the electrode active material according to the present invention

### ① Embodiment 1

First, a plate-shaped graphite having an average particle size of 4 µm is prepared as the carbon-based material. Subsequently, the prepared carbon-based material of 10g is put into a rotary furnace and an internal atmosphere of the rotary furnace is replaced with a nitrogen atmosphere in a vacuum. The interior of the rotary furnace is heated up to 550°C, and then, SiH₄ and CH₄ are made to flow into the rotary furnace for about 20 minutes. In this manner, the silicon layer is coated on the carbon-based material. Subsequently, the carbon-based material on which the silicon layer is deposited is put into a spheroidization equipment where reassembling is performed. The reassembling is performed by putting the carbon-based material on which the silicon layer is deposited into the spheroidization equipment, applying a bending on the carbon-based material, and mechanically reassembling the composite such that the silicon layer is moved and positioned inside the carbon-based material.

### ② Embodiment 2

First, a plate-shaped graphite having an average particle size of 4 µm is prepared as the carbon-based material. Subsequently, the prepared carbon-based material of 10g is put into a rotary furnace and an internal atmosphere of the rotary furnace is replaced with a nitrogen atmosphere in a vacuum. The interior of the rotary furnace is heated up to 550°C, and then, SiH₄ and CH₄ are made to flow into the rotary furnace for about 20 minutes. In this manner, the silicon layer is coated on the carbon-based material. Subsequently, the carbon-based material on which the silicon layer is deposited is put into a spheroidization equipment where reassembling is performed. The reassembling is performed by putting the carbon-based material on which the silicon layer is deposited into the spheroidization equipment, applying a bending on the carbon-based material, and mechanically reassembling the composite such that the silicon layer is moved and positioned inside the carbon-based material. After the reassembling, the reassembled composite is put into a reaction chamber and is heated to 675°C to perform the heat treatment. Then, air-cooling is performed.

### ③ Embodiment 3

First, a plate-shaped graphite having an average particle size of 4 µm is prepared as the carbon-based material. Subsequently, the prepared carbon-based material of 10g is put into a rotary furnace and an internal atmosphere of the rotary furnace is replaced with a nitrogen atmosphere in a vacuum. The interior of the rotary furnace is heated up to 550°C, and then, SiH₄ and CH₄ are made to flow into the rotary furnace for about 20 minutes. In this manner, the silicon layer is coated on the carbon-based material. Subsequently, the carbon-based material on which the silicon layer is deposited is put into a spheroidization equipment where reassembling is performed. The reassembling is performed by putting the carbon-based material on which the silicon layer is deposited into the spheroidization equipment, applying a bending on the carbon-based material, and mechanically reassembling the composite such that the silicon layer is moved and positioned inside the carbon-based material. After the reassembling, the reassembled composite is put into a reaction chamber and is heated to 800°C to perform the heat treatment. Then, air-cooling is performed.

### ④ Embodiment 4

First, a plate-shaped graphite having an average particle size of 4 µm is prepared as the carbon-based material. Subsequently, the prepared carbon-based material of 10g is put into a rotary furnace and an internal atmosphere of the rotary furnace is replaced with a nitrogen atmosphere in a vacuum. The interior of the rotary furnace is heated up to 550°C, and then, SiH₄ and CH₄ are made to flow into the rotary furnace for about 20 minutes. In this manner, the silicon layer is coated on the carbon-based material. Subsequently, the carbon-based material on which the silicon layer is deposited is put into a spheroidization equipment where reassembling is performed. The reassembling is performed by putting the carbon-based material on which the silicon layer is deposited into the spheroidization equipment, applying a bending on the carbon-based material, and mechanically reassembling the composite such that the silicon layer is moved and positioned inside the carbon-based material. After the reassembling, the reassembled composite is put into a reaction chamber and is heated to 900°C to perform the heat treatment. Then, air-cooling is performed.

As a result of conducting performance tests using the electrode active materials manufactured in the above manner, it can be confirmed that the electrode active materials according to an embodiment of the present invention can provide excellent cycle characteristics while ensuring high capacity as a whole, as shown in FIG. 3. Further, it can be confirmed that, unlike the conventional techniques, the electrode active materials according to an embodiment of the present invention can stably exhibit a high capacity retention ratio of 90% or higher even after the charge-discharge is performed 50 times.

Although the present invention has been described above by way of particular matters such as specific components and the like, specific embodiments and the accompanying drawings, such descriptions are merely provided for the sake of easier understanding of the present invention. The present invention is not limited to the above embodiments, but various modifications and variations may be made by those skilled in the art.

Therefore, the spirit of the present invention should not be limited to the above-described embodiments, and it should be construed that the appended claims as well as all equivalents or equivalent modifications of the appended claims will fall within the scope of the present invention.

## Claims

1. An electrode active material for secondary battery, comprising:
composite having silicon layer formed on carbon-based material,
wherein the composite is formed as a unit powder,
wherein the composite comprises the silicon layer inside the carbon-based material, and is configured such that silicon is not exposed to an outer surface of the carbon-based material or locally exposed to only a portion of the outer surface of the carbon-based material, and
wherein the silicon layer is configured to include both silicon and carbon.

2. The electrode active material for secondary battery according to Claim 1, wherein the composite comprises the silicon layer only inside the carbon-based material, and is configured such that silicon is not exposed to the outer surface of the carbon-based material.

3. The electrode active material for secondary battery according to Claim 1, wherein the silicon layer is configured such that carbon is included in the silicon layer in a range of 17wt% to 27wt% with respect to a total weight of the silicon layer.

4. The electrode active material for secondary battery according to Claim 3, wherein silicon included in the silicon layer has a particle diameter of 0.1 nm to 10 nm.

5. The electrode active material for secondary battery according to Claim 4, wherein silicon included in the silicon layer has the particle diameter of 2 nm to 5 nm.

6. The electrode active material for secondary battery according to Claim 4, wherein the silicon layer is formed such that SiC forms a base material and the silicon particles are distributed inside the SiC base material.

7. The electrode active material for secondary battery according to Claim 4, wherein silicon is included in the composite in exceed of 10wt% with respect to the total weight of the composite.

8. The electrode active material for secondary battery according to Claim 7, wherein silicon is included in the composite in exceed of 15wt% with respect to the total weight of the composite.

9. The electrode active material for secondary battery according to Claim 4, wherein the silicon layer is deposited and formed on the carbon-based material by supplying both a first raw material gas containing silicon and a second raw material gas containing carbon.

10. The electrode active material for secondary battery according to Claim 9, wherein the first raw material gas containing silicon includes at least one gas selected from a group consisting of SiH₄, Si₂H₆, Si₃H₈, SiCl₄, SiHCl₃, Si₂Cl₆, SiH₂Cl₂, and SiH₃Cl, and the second raw material gas containing carbon includes at least one gas selected from a group consisting of C₂H₄, C₂H₂, and CH₄.

11. The electrode active material for secondary battery according to Claim 10, further comprising a surface layer provided on an outer peripheral surface of the composite.

12. The electrode active material for secondary battery according to Claim 11, wherein the surface layer is formed of at least one carbon-based material selected from a group consisting of a coal tar pitch, a petroleum-based pitch, an epoxy resin, a phenolic resin, a polyvinyl alcohol, a polyvinyl chloride, an ethylene, an acetylene, and a methane.

13. A negative electrode for secondary battery, comprising the electrode active material for secondary battery according to any one of Claims 1 to 12.

14. A secondary battery comprising:
a positive electrode;
the negative electrode of Claim 13; and
an electrolyte provided between the positive electrode and the negative electrode.

15. A method of manufacturing an electrode active material for secondary battery, the method comprising:
a base material preparation step of preparing a carbon-based material used as a base material;
a silicon layer formation step of forming a silicon layer on the carbon-based material; and
a spheroidization step of reassembling the carbon-based material on which the silicon layer is formed, wherein
in the silicon layer formation step, the silicon layer is formed such that silicon and carbon are included in the silicon layer, and
the silicon layer is configured to be located inside the carbon-based material through the spheroidization step, and is configured such that silicon is not exposed to an outer surface of the carbon-based material or locally exposed to only a portion of the outer surface of the carbon-based material.

16. The method according to Claim 15, wherein in the silicon layer formation step, the silicon layer is deposited and formed as a thin film layer on the carbon-based material through a chemical vapor deposition.

17. The method according to Claim 16, wherein in the silicon layer formation step, the silicon layer is deposited and formed as the thin film layer on the carbon-based material by simultaneously supplying a first raw material containing silicon and a second raw material containing carbon.

18. The method according to Claim 17, wherein the first raw material gas containing silicon includes at least one gas selected from a group consisting of SiH₄, Si₂H₆, Si₃H₈, SiCl₄, SiHCl₃, Si₂Cl₆, SiH₂Cl₂, and SiH₃Cl, and the second raw material gas containing carbon includes at least one gas selected from a group consisting of C₂H₄, C₂H₂, and CH₄.

19. The method according to Claim 18, wherein in the silicon layer formation step, the silicon layer is formed to include carbon in a range of 17wt% to 27wt% with respect to a total weight of the silicon layer.

20. The method according to Claim 19, wherein silicon included in the silicon layer has a particle diameter of 0.1 nm to 10 nm.

21. The method according to Claim 20, wherein silicon included in the silicon layer has the particle diameter of 2 nm to 5 nm.

22. The method according to Claim 20, wherein silicon is included in the composite in exceed of 10wt% with respect to the total weight of the composite that forms the electrode active material.

23. The method according to Claim 22, wherein the silicon particles are included in the composite in exceed of 15% by weight with respect to the total weight of the composite that forms the electrode active material.

24. The method according to Claim 20, wherein the spheroidization step comprises:
putting the carbon-based material on which the silicon layer is deposited into a spheroidization equipment, rotating the spheroidization equipment at a high speed to grind the carbon-based material on which the silicon layer is deposited, and reassembling fragments dropped by the grinding to spheroidize the carbon-based material on which the silicon layer is deposited; or
edge-cutting the carbon-based material on which the silicon layer is deposited or applying a bending on the carbon-based material on which the silicon layer, and reassembling a structure by crumpling the carbon-based material on which the silicon layer to spheroidize the carbon-based material on which the silicon layer is deposited.

25. The method according to Claim 24, further comprising a surface layer formation step of forming a surface layer on an outer peripheral surface of the carbon-based material on which the silicon layer after the spheroidization step.

26. The method according to Claim 25, further comprising a modification step of modifying a surface property of the carbon-based material used as a base material between the base material preparation step and the silicon layer formation step.
